(19) Europäisches Patentamt
European Patent Office
Office européen des brevets

(11) **EP 3 170 010 B1**

(12) **EUROPÄISCHE PATENTSCHRIFT**

(45) Veröffentlichungstag und Bekanntmachung des Hinweises auf die Patenterteilung:
**23.06.2021 Patentblatt 2021/25**

(21) Anmeldenummer: **15745147.7**

(22) Anmeldetag: **17.07.2015**

(51) Int Cl.:
***H02M 1/00*** *(2006.01)*       ***G01R 19/00*** *(2006.01)*

(86) Internationale Anmeldenummer:
**PCT/EP2015/001481**

(87) Internationale Veröffentlichungsnummer:
**WO 2016/008594 (21.01.2016 Gazette 2016/03)**

(54) **VORRICHTUNG UND VERFAHREN ZUR STROMMESSUNG**

DEVICE AND METHOD FOR MEASURING CURRENT

DISPOSITIF ET PROCÉDÉ DE MESURE DE COURANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.07.2014 DE 102014010522**

(43) Veröffentlichungstag der Anmeldung:
**24.05.2017 Patentblatt 2017/21**

(73) Patentinhaber: **Technische Universität Braunschweig**
**38106 Braunschweig (DE)**

(72) Erfinder: **LANGMAACK, Niklas**
**38116 Braunschweig (DE)**

(74) Vertreter: **Ahrens, Thomas**
**Patentanwalt & Mediator**
**Unterdorf 10**
**38104 Braunschweig (DE)**

(56) Entgegenhaltungen:
**WO-A1-2005/004318       DE-A1-102012 217 472**
**US-A- 5 815 391**

**EP 3 170 010 B1**

**Beschreibung**

Die vorliegende Erfindung betrifft ein Verfahren sowie eine zugehörige Vorrichtung zur Messung von Lastströmen, die von einer elektrischen Versorgungseinrichtung mit zwei wechselseitig geschalteten Leistungsstufen an einen Verbraucher abgegeben werden.

Elektrische Versorgungseinrichtungen mit zwei wechselseitig geschalteten Leistungsstufen sind allgemein bekannt. So beschreibt beispielsweise die deutsche Offenlegungsschrift DE 10 2009 046 255 A1 eine Halbbrückenschaltung, auch Halbbrückenanordnungen genannt. Derartige Versorgungseinrichtungen können bei verschiedenen Anwendungen eingesetzt werden, wie beispielsweise bei Schaltnetzteilen, Wechselrichtern oder Antriebswechselrichtern in einem zumindest teilweise elektrisch angetriebenen Fahrzeug, also einem Hybrid-, einem Elektrofahrzeug oder dergleichen. Die zugehörigen Leistungsstufen weisen üblicherweise Leistungshalbleiter auf, die als Schaltelemente arbeiten. Diese werden versorgt von einer geeigneten Spannungsquelle, die elektrische Leistung abgibt, und angesteuert von geeigneten Treiberstufen, wie beispielsweise von Gate-Treibern.

Elektrische Versorgungseinrichtungen der genannten Art geben einen Strom - im Folgenden auch Laststrom genannt - ab, der sowohl einen Gleichstromanteil als auch einen Wechselstromanteil enthalten kann. Es ist für verschiedene Anwendungen notwendig, den Wert des Laststroms zu bestimmen, wie beispielsweise zur Regelung dieses Stromes, zur Anzeige des Betriebszustandes für einen Nutzer der zugehörigen Anlage, usw.

Für die Bestimmung des Wertes des Laststromes gibt es verschiedene Möglichkeiten, wie beispielsweise die Verwendung von (a) Shuntwiderständen, (b) Kompensationswandlern (closed-loop) mit Hall-Sensor oder einer Feldsonde, (c) Hall-Messwandlern (open-loop) mit und ohne Kernmaterial oder dergleichen. Die Verwendung dieser Elemente weist jedoch verschiedene Nachteile auf. So ist insbesondere die Verwendung von Shuntwiderständen verlustbehaftet und ohne Potentialtrennung. Kompensationswandler und Hall-Messwandler brauchen einen großen Bauraum, weisen ein hohes Gewicht auf, sind recht teuer und können durch Überströme irreversibel geschädigt werden.

In der bereits genannten Schrift DE 10 2009 046 255 A1 ist auch bereits vorgeschlagen worden, eine Rogowski-Spule zur Messung des Stromgradienten des durch den Halbleiter fließenden Stroms während der Kommutierung - also während des Schaltvorgangs - zu verwenden. Dabei ist es allerdings nicht möglich, den Gleichstromanteil des Laststromes zu bestimmen.

Aus der europäischen Patentschrift EP 1 073 908 B1 - bzw. der zugehörigen deutschen Übersetzung DE 699 15 816 T2 - ist eine weitere Verwendung einer Rogowski-Spule für eine Strommesseinrichtung bekannt, bei der das Signal der Rogowski-Spule mittels eines Integrators aufbereitet wird.

Auch die deutsche Offenlegungsschrift DE 101 07 791 A1 beschreibt die Verwendung von Spulen, wie Zylinderspulen und Rogowski-Spulen, im Rahmen der Leistungselektronik. Die dort beschriebene Lösung weist jedoch die Nachteile auf, dass eine spezielle Abtast- und Halteelektronik notwendig ist und auch ein kompliziertes Timing eingehalten werden muss, das eine Anpassung an den jeweiligen Leistungshalbleiter notwendig macht.

Die deutsche Offenlegungsschrift DE 10 2012 210 261 A1 beschreibt ein Leistungshalbleitermodul und ein Verfahren zu dessen Betrieb. Dort wird konkret eine Halbbrückenschaltung beschrieben wobei zur Ermittlung der Lastströme verschiedene Spulen vorgesehen sind. Erste dieser Spulen befinden sich unmittelbar neben einer Laststromleiterbahn bzw. einem Laststromleiter eines ersten Leistungshalbleiterschalters. Zweite dieser Spulen befinden sich unmittelbar neben einer zweiten Laststromleiterbahn oder einem zweiten Laststromleiter eines zweiten Leistungshalbleiterschalters. Die Signale der ersten Spulen und die Signale der zweiten Spulen werden jeweils zugehörigen Integrierern zugeführt und anschließend entsprechend ausgewertet.

Die Patentschrift US 5,815,391 betrifft eine Erfindung zur Messung des Inverter-Stroms bei einem Treiber mit Puls-Weiten-Modulation (PWM) zur Ansteuerung eines Motors ohne Verwendung eines Hallsensors. Nach der dortigen Erfindung können auch Rogowskispulen im Bereich der Eingangsleitungen oder der Ausgangsleitungen der beiden Inverter-Schalter des genannten Treibers angeordnet sein. Jede dieser Spulen ist mit einem Integrator verbunden. Dabei weisen beide Integratoren jeweils eine Resetstufe auf, die das Ausgangssignal des zugehörigen Integrators auf Null hält während der Aus-Zeit des zugehörigen PWM-Signals für den zugehörigen Inverter-Schalter. Um die Ausgangssignale der beiden Integratoren für die Motorsteuerung verwenden zu können, ist außerdem ein Summen-Verstärker nötig.

Es ist die Aufgabe der vorliegenden Erfindung, eine Vorrichtung - sowie auch ein , entsprechendes Verfahren - zu realisieren, mit der ein Laststrom, der von einer Versorgungseinrichtung der oben genannten Art abgegeben wird, auf einfache und zuverlässige Weise bestimmt werden kann.

Die genannte Aufgabe wird durch eine erfindungsgemäße Vorrichtung nach dem Hauptanspruch bzw. durch ein erfindungsgemäßes Verfahren nach dem ersten Verfahrensanspruch gelöst. Die Unteransprüche enthalten vorteilhafte Ausgestaltungen.

Die Erfindung geht von folgenden Erkenntnissen aus. Elektrische Versorgungseinrichtungen der oben genannten Art, wie insbesondere Halbbrückenschaltungen, enthalten zwei Leistungsstufen, von denen mindestens eine von einem Treiber periodisch angesteuert werden kann, wobei sie üblicherweise periodisch ein- und ausgeschaltet werden. Dabei kann die Periode des Einschaltens gleich lang sein wie die Periode des Ausschaltens. Üblicherweise hat die Einschalt-Periode jedoch eine andere Dauer als die Ausschalt-Periode.

Beide Leistungsstufen werden wechselseitig ein- bzw. ausgeschaltet. Das heißt, wenn eine der Stufen eingeschaltet ist, ist die jeweils andere Stufe ausgeschaltet. Beim Einschalten einer dieser Stufen wird diese leitend, so dass aufgrund einer anliegenden Spannung, die von einer geeigneten Stromquelle bereit gestellt wird, ein Strom fließen kann. Beim Ausschalten dieser Stufe wird dieser Stromfluss unterbrochen. Diese Schaltvorgänge erfolgen jedoch mit endlicher Stromänderungsrate (di/dt), wobei die Stromänderungsraten in den Schaltzeitpunkten im Wesentlichen gleich sind.

Bei der erfindungsgemäßen Bestimmung des Laststromes ist ein erster induktiver Sensor im Bereich einer ersten Speiseleitung angeordnet, über die die erste der beiden Leistungsstufen von der Stromquelle versorgt wird. Außerdem befindet sich ein zweiter induktiver Sensor im Bereich einer zweiten Speiseleitung, über die die zweite der beiden Leistungsstufen von der Stromquelle versorgt wird. Dabei sind die Sensoren in Bezug auf ihre zugehörige Leitung jeweils derart angeordnet, dass bei entsprechendem Stromfluss eine angemessene Spannung induziert wird, die außerdem insbesondere abhängig ist von den Abmessungen und der Geometrie der Sensoren. Es ist ebenfalls möglich, dass im Bereich der ersten Speiseleitung und/oder im Bereich der zweiten Speiseleitung jeweils mehr als ein induktiver Sensor angeordnet ist, die in geeigneter Weise verschaltet sind. Ein Laststrom, der durch eine der Leistungsstufen fließt, kann sowohl im Bereich der genannten Speiseleitungen, die üblicherweise direkt oder indirekt mit einer Spannungs- bzw. Stromquelle verbunden sind, als auch im Bereich der Ausgangsleitungen der Leistungsstufen gemessen werden. Diese Ausgangsleitungen sind üblicherweise direkt oder indirekt zusammengeschaltet und versorgen einen Verbraucher (Last), der mit dem gewünschten Leistungsstrom versorgt werden soll. Bei einigen Leistungshalbleiterschaltungen ist zwar eine kleine Differenz zwischen den Strommessungen an den Speiseleitungen und denen an den Ausgangsleitungen vorhanden, jedoch sind diese kleinen Differenzen üblicherweise vernachlässigbar. Daher erlaubt die vorliegende Erfindung, dass erste induktive Sensoren im Bereich der Speiseleitungen und/oder im Bereich der Ausgangsleitungen der ersten der genannten Leistungsstufen angeordnet sind. Gleiches gilt für zweite der induktiven Sensoren, die für die Strommessung der zweiten Leistungsstufe vorhanden sind.

Erfindungsgemäß sind die ersten induktiven Sensoren und die zweiten induktiven Sensoren in Reihe geschaltet.

Die von den induktiven Sensoren erzeugten Spannungen werden integriert. Die erfindungsgemäße Reihenschaltung der Sensoren hat den besonderen Vorteil, dass nur ein Integrator notwendig ist für die Auswertung der Sensorsignale. Ein geeigneter Integrator kann auf vielfältige Weise gestaltet werden. Eine mögliche Realisierung ist bekannt aus der oben genannten Schrift DE 699 15 816 T2. Es sind zusätzlich oder stattdessen auch andere Integratoren möglich, wie

- direkte Wandlung mithilfe eines Analog-Digital-Wandlers mit sehr hoher Bandbreite und anschließender digitaler Integration,

- passiver oder aktiver analoger Integration mit anschließender sequenzieller Abtastung und Wandlung mittels eines Analog-Digital-Wandlers und/oder durch

- analoge Integration, wobei die Abtastung mit mehreren Haltegliedern parallel durchgeführt wird.

Die integrierten Sensorsignale werden zu vorgegebenen Zeitpunkten innerhalb der Schaltperioden ausgelesen. Dieses Auslesen kann einmal oder mehrfach während einer Einschalt-Periode und/oder einmal oder mehrfach während einer Ausschalt-Periode erfolgen. In einer bevorzugten Ausführungsform erfolgt das Auslesen nur einmal pro Einschalt-Periode und einmal pro Ausschalt-Periode. Dabei hat es sich besonders bewährt, wenn das jeweils im Wesentlichen mitten innerhalb einer jeden Schalt-Periode erfolgt, wobei nochmals darauf hingewiesen wird, dass die Einschalt-Periode eine andere Dauer haben kann als die Ausschalt-Periode.

Das genannte Auslesen der integrierten Sensorsignale zu vorgegebenen Zeitpunkten führt zu einer Reihe von Messwerten. Durch Bildung der Differenz von zwei derartig ermittelten Messwerten kann ein Wert für den Laststrom ermittelt werden, der von der Versorgungseinrichtung abgegeben wird und üblicherweise einen Gleichstrom- und einen Wechselstromanteil aufweist.

Durch geeignete Mittel, wie eine Steuereinheit, wird mindestens ein Ausgangssignal erzeugt, dessen Wert abhängig ist von dem Wert des ermittelten Laststromes. Das Ausgangssignal (bzw. die Ausgangssignale) kann vielfältig verwendet werden, wie zur Steuerung unterschiedlicher Betriebszustände der Gesamteinrichtung (Schaltnetzteil, Wechselrichter, Fahrzeug, usw.), bei der die Versorgungseinrichtung verwendet wird. Weitere Möglichkeiten sind - zusätzlich oder stattdessen:

- Regelung des Stroms, der von der Versorgungseinrichtung abgegeben wird.
- Erkennung eines Überstroms,
- Erkennung eines Kurzschlusses in der Versorgungsvorrichtung.

Dabei kann das Ausgangssignal (bzw. die Ausgangssignale) dazu verwendet werden, es direkt weiteren Steuerstufen zuzuführen. Es ist zusätzlich oder stattdessen auch möglich, dass optische Signale - wie Anzeige von alphanumerischen Zeichen, Balkengrafik oder dergleichen - und/oder akustische Signale - wie Signaltöne mit unterschiedler Frequenz und/oder Lautstärke, Sprachausgabe oder dergleichen - erzeugt werden, die einem Nutzer einen Hinweis auf den Betriebszustand der Vorrichtung geben.

Die Erfindung ist besonders kostengünstig und zuverlässig, sowohl bei der Herstellung als auch im Betrieb, wenn zumindest einer der induktiven Sensoren direkt auf einer Platine angeordnet ist. Auf dieser können sich auch andere Bauelemente befinden. Dabei kann die Platine auch eine Öffnung (oder mehrere) aufweisen, um die zumindest einer der induktiven Messsensoren als metallisches Element angeordnet ist und durch die zumindest eine der oben genannten Leitungen der Leistungsstufen hindurch verläuft. Es hat sich besonders bewährt, eine Platine mit doppelseitiger Metallschicht zu verwenden, wobei beide Metallschichten entsprechend eines zugehörigen Layouts strukturiert werden und dadurch zumindest einen der induktiven Messsensoren realisieren. Es ist natürlich ebenfalls möglich, dass beide dieser Stromversorgungsleitungen durch jeweils eine Öffnung verlaufen und dass im Bereich jeder dieser Öffnungen ein zugehöriger induktiver Sensor angeordnet ist.

Weitere Einzelheiten und Vorteile der vorliegenden Erfindung werden im Folgenden anhand von bevorzugten Ausführungsbeispielen mit zugehörigen Abbildungen erläutert. Dabei zeigen

Fig. 1 ein Prinzipschaltbild einer Halbbrückenanordnung mit Messung des Laststromes
Fig. 2 ein Schaltbild des in Fig. 1 enthaltenen Integrators
Fig. 3 das obere Layout für eine bevorzugte Rogowskispule
Fig. 4 das untere Layout für die bevorzugte Rogowskispule
Fig. 5 Kombination der Layouts aus Fig. 3 und Fig. 4
Fig. 6 verschiedene Signalverläufe.

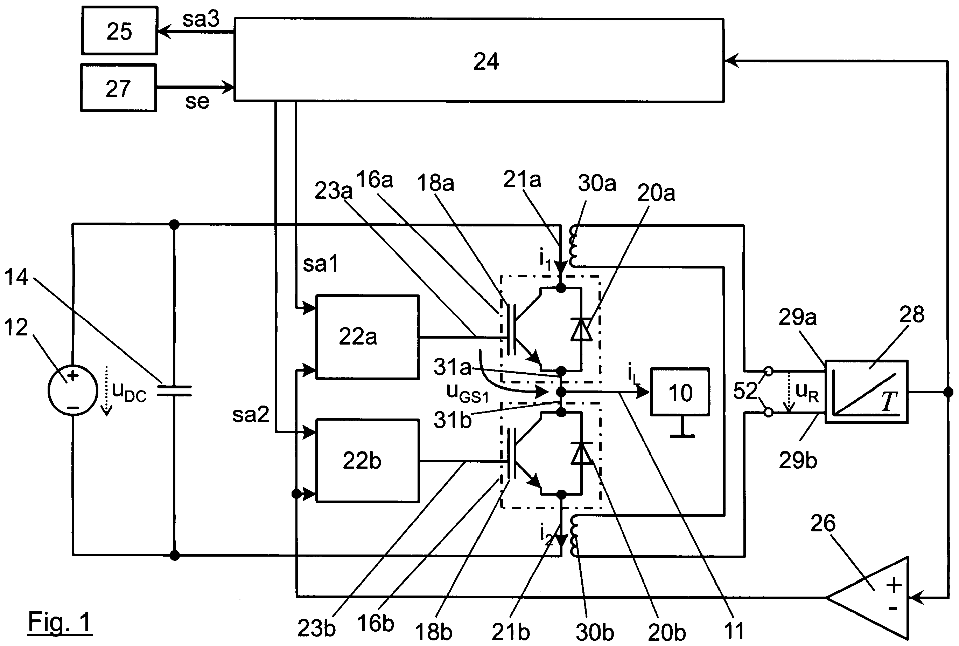

Fig. 1 zeigt das Prinzipschaltbild einer Halbbrückenanordnung zur Versorgung eines Verbrauchers 10 mit einer elektrischen Leistung bzw. einem entsprechenden Laststrom $i_L$. Die Anordnung wird gespeist von einer Spannungsquelle 12, die eine Gleichspannung $U_{DC}$ abgibt und der ein Glättungskondensator 14 parallel geschaltet ist. Die Halbbrückenanordnung weist eine obere Stufe 16a und eine untere Stufe 16b auf. Die obere Stufe 16a enthält einen oberen Schalttransistor 18a und eine zugehörige obere Freilaufdiode 20a und ist über eine Speiseleitung 21a mit dem Pluspol der Spannungsquelle 12 verbunden. Dementsprechend enthält die untere Stufe 16b einen unteren Schalttransistor 18b und eine zugehörige Freilaufdiode 20b und ist über eine Speiseleitung 21b mit dem Minuspol der Spannungsquelle 12 verbunden. Die Ausgangsleitung 31a der oberen Stufe 16a und die Ausgangsleitung 31b der unteren Stufe sind direkt oder indirekt zusammengeschaltet und versorgen über die Leitung 11 gemeinsam den Verbraucher 10 mit dem Laststrom $i_L$. Die Schalttransistoren 18 können verschieden ausgeführt sein, wie beispielsweise als MOS-Feldeffekttransistor (MOSFET), als Bipolar-Transistor mit isoliertem Gate (IGBT), als Bipolar-Transistor, als Feldeffekttransistor (FET), aber auch als Gate Turn Off Thyristor (GTO), als Thyristor oder dergleichen.

Der obere Schalttransistor 18a wird angesteuert von einem oberen Gate-Treiber 22a über eine Steuerleitung 23a und der untere Schalttransistor 18b wird angesteuert von einem unteren Gate-Treiber 22b über eine Steuerleitung 23b. Jeweils ein erster Eingang dieser Treiber 22 ist mit jeweils einem Ausgang einer Steuereinheit 24 verbunden, die darüber Ausgangssignale sa1, sa2 an die Treiber 22a bzw. 22b abgibt. Eine geeignete Steuereinheit 24 ist dem Fachmann allgemein bekannt und kann beispielsweise als DSP Einheit ausgeführt sein (DSP = Digital Signal Processing). Ein weiterer Ausgang der Steuereinheit 24 gibt ein weiteres Ausgangssignal sa3 an den Eingang einer Anzeigeeinheit 25 ab, die derart gestaltet ist, dass sie Signale optisch und/oder akustische wiedergeben kann. Außerdem ist eine Eingabeeinheit 27 vorgesehen, über die Steuersignale se von einem Nutzer der Steuereinheit 24 zugeführt werden können.

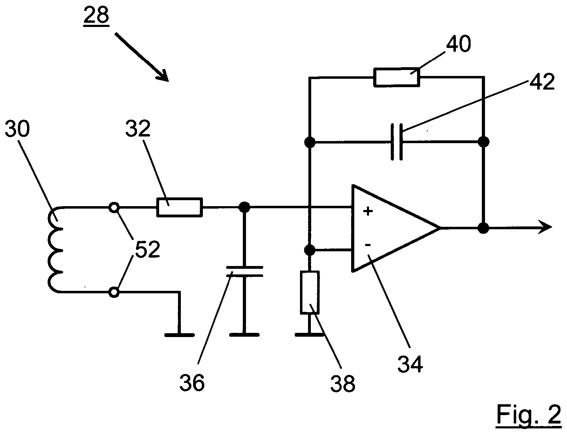

Zweite Eingänge der Gate-Treiber 22 sind gemeinsam verbunden mit dem Ausgang eines Komparators 26. Der Eingang dieses Komparators 26 ist verbunden mit einem Eingang der Steuereinheit 24 sowie mit dem Ausgang eines Integrators 28, der unten mithilfe von Fig. 2 näher beschrieben wird. Der Übersichtlichkeit wegen ist der Komparator 26 in Fig. 1 stark vereinfacht dargestellt. Tatsächlich weist er noch einen weiteren Eingang auf, der hier nicht dargestellt ist und an den ein fester Spannungswert als Überstromgrenze vorgegeben wird. Außerdem ist es sinnvoll, zwei Komparatoren vorzusehen, nämlich einen für die Überstromerkennung in positive Richtung und einen weiteren für die Überstromerkennung in negative Richtung. Diese Schaltung kann als Kurzschluss- oder Überstromerkennung dienen und ein sicheres Ausschalten oder Sperren beider Treiberschaltungen 22a und 22b, unabhängig von der Steuerungsvorrichtung 24, veranlassen.

Die Eingänge 29a, 29b des Integrators 28 sind verbunden mit einer Rogowskispule 30, die in diesem Prinzipschaltbild einen oberen Teil 30a und einen unteren Teil 30b aufweist, die miteinander in Reihe geschaltet sind. Der von den Stufen 16a, 16b erzeugte Laststrom $i_L$ wird dem Verbraucher 10 über eine Leitung 11 zugeführt.

Fig. 2 zeigt eine bevorzugte Ausführung des Integrators 28. An dessen Eingang befindet sich die Rogowskispule 30, also die Reihenschaltung aus den beiden Teilen 30a und 30b. Die Spule 30 ist über einen Widerstand 32 einerseits mit einem ersten Eingang (+) eines Operationsverstärkers 34 und andererseits mit einem Kondensator 36 verbunden. Der zweite Eingang (-) des Operationsverstärkers 34 ist einerseits über einen weiteren Widerstand 38 mit Masse verbunden. Ein weiterer Widerstand 40 sowie ein dazu parallel geschalteter Kondensator 42 verbinden den zweiten Eingang (-) mit dem Ausgang des Operationsverstärkers 34. Der Ausgang des Operationsverstärkers 34 - und somit des Integrators 28 - ist sowohl mit der Steuereinheit 24 als auch mit dem Komparator 26 verbunden (s.a. Fig. 1). Über diesen Ausgang wird in dem bevorzugten Ausführungsbeispiel ein analoges Signal abgegeben, das innerhalb der Steuereinheit 24 von einem hier nicht dargestellten Analog-Digital-Wandler digitalisiert wird.

Die Rogowskispule 30 ist, wie allgemein üblich, als Luftspule realisiert. Für einen möglichst robusten und kompakten Aufbau ist sie in der bevorzugten Ausführungsform als besonderes Bauelement gestaltet, dessen Leiter auf einer Platine angeordnet ist, die auch andere - oder ggf. alle - der elektronischen bzw. elektrischen Bauelemente aus den zuvor gezeigten Schaltungen aufnimmt.

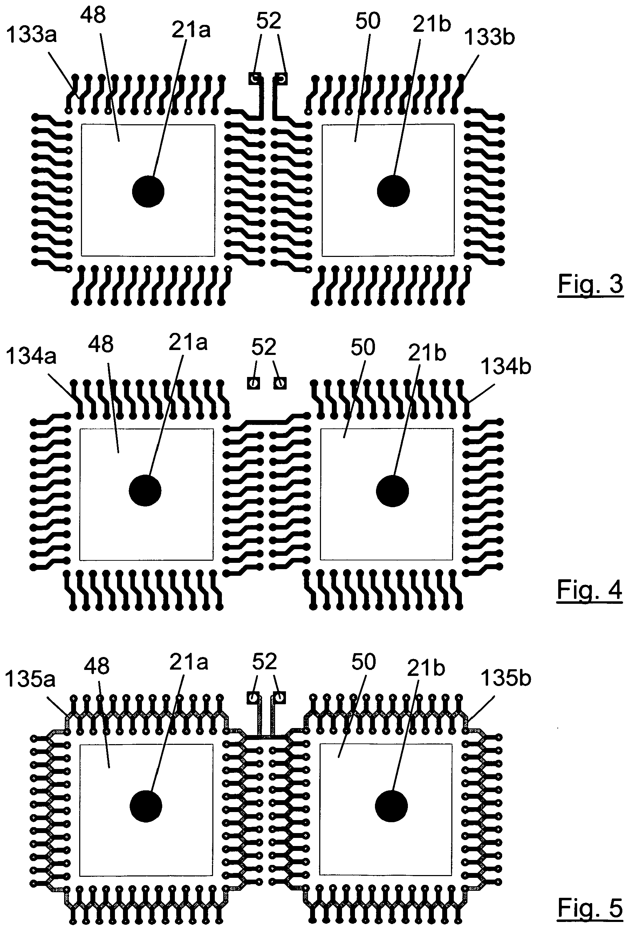

Die Figuren 3 - 5 zeigen das prinzipielle Layout 130 der Rogowskispule 30, wie sie in der bevorzugten Ausführung auf einer doppelseitigen Platine (hier nicht dargestellt) realisiert wird. Dabei zeigt Fig. 3 das Layout 133 für die eine - beispielsweise die obere - Seite der Platine und Fig. 4 zeigt das Layout 134 für die andere Platinenseite. In Fig. 5 ist symbolisch die Kombination 135 aus den beiden genannten Layouts dargestellt. Die Darstellung der Layouts 133, 134, 135 ist jeweils unterteilt in einen ersten Teil a und einen zweiten Teil b. Dieses entspricht der Unterteilung der Rogowskispule 30, wie in Fig. 1 dargestellt. Von diesem genannten Beispiel ausgehend stellt das Layout 133 die Metallbahnen auf der Oberseite und das Layout 134 die Metallbahnen auf der Unterseite der Platine dar. Derartige Metallbahnen bestehen üblicherweise aus Kupfer.

Im betriebsbereiten Zustand verlaufen diese Metallbahnen um eine erste Öffnung 48, die in den Figuren 3 - 5 links dargestellt ist, sowie um eine zweite Öffnung 50, die jeweils rechts dargestellt ist. Diese beiden Öffnungen 48, 50 können innerhalb der Platine durch geeignete Verarbeitungsschritte erzeugt werden, wie durch Fräsen, Bohren, Sägen, Ätzen, Stanzen und/oder dergleichen. Die Anschlüsse 52 dienen dazu, die Rogowskispule 30 mit dem Integrator 28 zu verbinden (s.a. Fig. 1 und 2).

Im betriebsbereiten Zustand verläuft außerdem die Leitung 21a durch die Öffnung 48 und die Leitung 21b durch die Öffnung 50. Über die Leitung 21a wird die obere Stufe 16a mit einem Strom $i_1$ gespeist, dessen Wert abhängig ist von der Ansteuerung des oberen Schalttransistors 18a durch den Gate-Treiber 22a. Entsprechend wird die untere Stufe 16b über die Leitung 21b mit einem Strom $i_2$ gespeist, dessen Wert abhängig ist von der Ansteuerung des Schalttransistors 18b durch den Gate-Treiber 22b.

Wenn der obere Schalttransistor 18a leitend geschaltet wird, gilt

$$(1) \qquad i_1 = i_L, \ i_2 = 0$$

und wenn der untere Schalttransistor 18b leitend geschaltet wird, gilt

$$(2) \qquad i_1 = 0, \ i_2 = - \, i_L,$$

wobei $i_L$ der Laststrom ist, der an den Verbraucher 10 über die Leitung 11 abgegeben wird.

Die Rogowskispule 30, die ja aus dem oberen Teil 30a und dem unteren Teil 30b besteht, wobei beide Teile 30a, 30b in Reihe geschaltet sind, gibt eine Spannung $U_R$ ab, für deren Wert gilt:

$$(3) \qquad U_R = M \, ^* \, di_1/dt \ + \ M \, ^* \, di_2/dt \ = M \, ^* \, (di_1/dt \ + \ di_2/dt),$$

wobei M die Koppelinduktivität der Rogowskispule 30 ist, die im Wesentlichen konstant ist und sich aus der Geometrie der Anordnung ergibt.

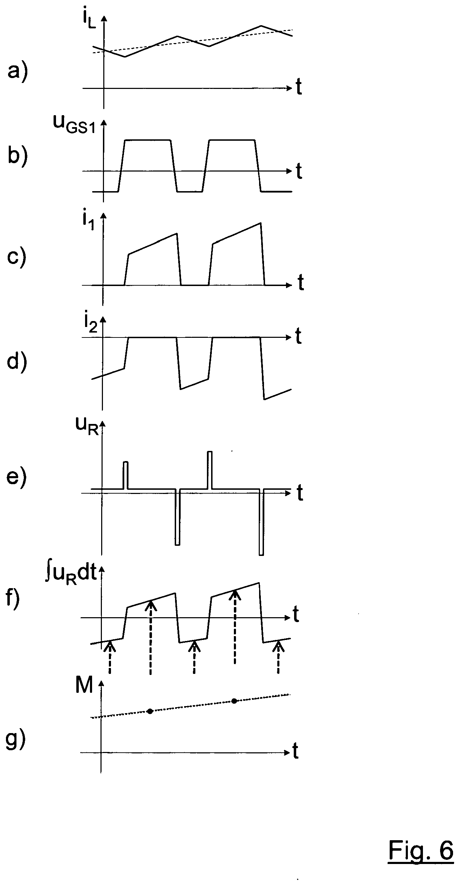

Durch das in den Fig. 1 bis 5 dargestellte Ausführungsbeispiel ist es möglich, den Laststrom $i_L$ zu ermitteln, der über die Leitung 11 an den Verbraucher 10 abgegeben wird. Das zugehörige Verfahren wird im Folgenden mit Hilfe von Fig. 6 beschrieben.

Üblicherweise besteht der Laststrom $i_L$ aus einem Gleichanteil, einem Wechselanteil, sowie einer gewissen Welligkeit mit der Periodizität der Schaltereignisse, wie in Fig. 6a dargestellt. Von besonderem Interesse ist dabei der Verlauf der Strommittelwerte, die in Fig. 6a gestrichelt dargestellt sind. Ein solcher Stromverlauf für $i_L$ entsteht, wenn die Schalttransistoren 18a und 18b abwechselnd durch die Gate-Treiber 22a, 22b ein- und ausgeschaltet werden. Fig. 6b zeigt beispielhaft den zugehörigen Verlauf der Spannung $u_{GS1}$ (s.a. Fig. 1) zur Ansteuerung des oberen Schalttransistors 18a. Wie durch die o.g. Formeln (1) und (2) angegeben, entspricht der Strom $i_1$ im oberen Schaltpfad 16a dem Laststrom $i_L$ bei leitendem Schalttransistor 18a und Null bei sperrendem Schalttransistor 18a. Dabei erfolgen die Schaltvorgänge mit endlichem di/dt. Der zugehörige Verlauf ist in Fig. 6c dargestellt. Der Strom $i_2$ im unteren Schaltpfad 16b entspricht - gemäß den oben genannten Formeln (2) bzw. (1) - dem Laststrom $i_L$ mit umgekehrtem Vorzeichen bei leitendem Schalttransistor 18b und Null bei sperrendem Schalttransistor 18b (s. Fig. 6d).

Die Rogowskispannung $U_R$, die von der Rogowskispule 30 an die Eingänge 29a, 29b des Integrators 28 abgegeben wird, ist proportional zur Stromänderungsrate (Fig. 6e). Durch Integration $\int U_R\, dt$ (s. Fig. 6f) kann der Verlauf des Stromes in den Zwischenkreisanschlüssen - Leitung 21a bzw. 21b - der Halbbrücke zurückgewonnen werden, allerdings ohne Gleichstromanteil.

Bei dem bevorzugten Ausführungsbeispiel tastet die Steuereinheit 24 das Ausgangssignal des Integrators 28 für die Strommessung zu vorgegebenen Zeitpunkten ab; und zwar zur Pulsmitte beider Schaltzustände. Diese Zeitpunkte sind in Fig. 6f durch Pfeile markiert und sie sind der Steuereinheit 24 bekannt, da sie die Steuertransistoren 18a, 18b über die Gate-Treiber 22a, 22b ansteuert.

Anhand der Information über den Schaltzustand der Schalttransistoren 18a, 18b kann der Gleichanteil des Laststromes $i_L$ bestimmt werden, da der Strom im jeweils sperrenden Schalttransistor 18 stets Null ist. Die Gleich- und Wechselstromanteile des Laststromes $i_L$ können daher bestimmt werden durch die Differenz aufeinander folgender abgetasteter Werte.

In Fig. 6g sind symbolisch die zugehörigen Messwerte M dargestellt. Genau gesagt, ergibt sich daraus der jeweilige Mittelwert des Laststromes $i_L$ innerhalb einer Pulsperiode des Schaltmusters. Dieser enthält den Gleichstrom- und den Wechselstromanteil des Laststromes $i_L$, jedoch nicht den hochfrequenten Anteil mit Schaltfrequenz, der üblicherweise auch nicht von Interesse ist.

Die in Fig. 1 gezeigte Schaltung erlaubt neben der Messung der Werte für den Strom $i_L$, die beispielsweise mittels der Anzeigeeinheit 25 optisch und/oder akustisch dargestellt werden können, auch eine entsprechende Regelung mit Hilfe der Steuereinheit 24.

Es ist außerdem möglich, dass eine Überstromgrenze vorgegeben wird. Dieses kann erfolgen aufgrund einer Spannung mit vorgegebenem Wert an dem zweiten Anschluss (hier nicht gezeigt) des Komparators 26. Es ist jedoch zusätzlich oder stattdessen auch möglich, dass ein entsprechender Grenzwert mittels der Eingabeeinheit 27 der Steuereinheit 24 zugeführt wird.

Die beschriebenen Ausführungsbeispiele sind zwar bevorzugt. Es sind jedoch zahlreiche Abwandlungen möglich, durch die die vorliegende Erfindung dennoch realisiert werden kann. Denkbar ist insbesondere:

- anstelle oder zusätzlich zu der Rogowskispule 30 ohne ferromagnetischen Träger können auch andere Spulenanordnungen als induktiver Messsensor verwendet werden. Diese können mit oder ohne ferromagnetischen Kern verwendet werden. Denkbar sind also auch Spulen, die direkt in eine Platine integriert werden und/oder auf einen Träger, der auch ferromagnetisch sein kann, gewickelt werden.
- Je Halbbrücke 16a, 16b können ein oder mehrere induktive Messsensoren vorgesehen werden. Dabei ist es auch denkbar, dass die Spule 30a (oder ein ähnlicher Messsensor) nicht (nur) oberhalb des Schalttransistors 18a - also im Bereich der Speiseleitung 21a - angeordnet ist, sondern zusätzlich oder stattdessen unterhalb davon, also zwischen dem Schalttransistor 18a und dem Abzweig zur Leitung 11. Gleiches gilt in ähnlicher Weise auch für die Anordnung von Messaufnehmern für die untere Stufe 16b.
- Die Halbbrückenanordnung enthält mindestens einen aktiv geschalteten Halbleiter oder es besteht wenigstens eine topologiebedingte feste Kopplung mit einer aktiv geschalteten Halbbrücke, wie zum Beispiel beim sekundären Gleichrichter in einem primär getakteten Schaltnetzteil.
- Die Integration der Stromänderungsrate di/dt kann auf unterschiedliche Weise erfolgen, wie beispielsweise durch

  ◦ direkte Wandlung mithilfe eines Analog-Digital-Wandlers mit sehr hoher Bandbreite und anschließender digitaler Integration,
  ◦ passiver oder aktiver analoger Integration mit anschließender sequenzieller Abtastung und Wandlung mittels eines Analog-Digital-Wandlers und/oder durch
  ◦ analoge Integration, wobei die Abtastung mit mehreren Haltegliedern parallel durchgeführt wird.

- Zur Regelung des Laststromes $i_L$ muss das gewandelte Signal mit dem Ansteuersignal der Halbbrücke verknüpft werden. Dies kann digital erfolgen in einer digitalen Steuereinheit 24, wie einem Mikrocontroller oder dergleichen, und/oder analog erfolgen in einer geeigneten Integratorschaltung.
- Die vorliegende Erfindung erlaubt verschiedene Anwendungen, wie insbesondere:

  ◦ die Bestimmung des Laststromes iL,
  ◦ die Ermittlung eines Überstromes der Halbbrücke 16a, 16b
  ◦ die Erkennung eines Kurzschlusses in der Halbbrücke 16a, 16b. Dabei können entsprechende optische und/akustische Signale mittels der Anzeigeeinheit 25 wiedergegeben werden. Zusätzlich oder stattdessen ist es auch möglich, dass die Steuereinheit 24 in einen anderen Betriebszustand schaltet oder die gesamte Stromversorgung ganz abschaltet.

- Die Informationen über die Stromänderungsrate di/dt in der Halbbrücke 16a, 16b kann weiterhin zu Folgendem genutzt werden:

- Rückschlüsse über die Lastinduktivität zu erhalten, z.B. für eine Maschinenregelung
- die Ansteuerung der Schalttransistoren 18a, 18b dahingehend zu beeinflussen, dass eine bestimmte Stromänderungsrate di/dt erzielt wird.

**Bezugszeichenliste**

| | |
|---|---|
| 10 | Verbraucher |
| 11 | Leitung |
| 12 | Spannungsquelle |
| 14 | Glättungskondensator |
| 16a, b | obere bzw. untere Stufe |
| 18a, b | oberer bzw. unterer Schalttransistor |
| 20a, b | obere bzw. untere Freilaufdiode |
| 21a, b | Speiseleitung von 16a bzw. 16b |
| 22a, b | oberer bzw. unterer Gate-Treiber |
| 23a, b | Steuerleitung von 16a bzw. 16b |
| 24 | Steuereinheit |
| 25 | Anzeigeeinheit |
| 26 | Komparator |
| 27 | Eingabeeinheit |
| 28 | Integrator |
| 29a, b | Eingänge von 28 |
| 30 | Rogowskispule |
| 30a, b | oberer bzw. unterer Teil von 30 |
| 31a, b | Ausgangsleitung von 16a bzw. 16b |
| 32 | Widerstand |
| 34 | Operationsverstärker |
| 36 | Kondensator |
| 38 | Widerstand |
| 40 | Widerstand |
| 42 | Kondensator |
| 48 | Erste Öffnung |
| 50 | Zweite Öffnung |
| 52 | Anschluss für 30 |
| 133 | Layout für obere Metalllage |
| 134 | Layout für untere Metalllage |
| 135 | Gesamtlayout |
| sa1, sa2, sa3 | verschiedene Ausgangssignale von 24 |
| se | Steuersignale |

**Patentansprüche**

1. Vorrichtung zur Bestimmung eines Laststromes ($i_L$), der von einer Versorgungseinrichtung abgegeben wird, die eine erste Leistungsstufe (16a) und eine zweite Leistungsstufe (16b) aufweist, wobei

- die erste Leistungsstufe (16a) über eine erste Speiseleitung (21a) mit einem ersten Speisestrom ($i_1$) gespeist werden kann und einen ersten Ausgangsstrom über eine erste Ausgangsleitung (31a) abgeben kann,
- die zweite Leistungsstufe (16b) über eine zweite Speiseleitung (21 b) mit einem zweiten Speisestrom ($i_2$) gespeist werden kann und einen zweiten Ausgangsstrom über eine zweite Ausgangsleitung (31b) abgeben kann,

- die Leistungsstufen (16a, 16b) über eine erste Steuerleitung (23a) bzw. über eine zweite Steuerleitung (23b) wechselseitig von einer Steuereinheit (24) für jeweils eine vorgegebene Schaltperiode mit endlicher Stromänderung (di/dt) geschaltet werden können, wodurch die Werte der Speiseströme ($i_1$; $i_2$) bzw. die Werte der Ausgangsströme beeinflusst werden,

- ein erster induktiver Messsensor (30a) im Bereich der ersten Speiseleitung (21a) und/oder im Bereich der ersten Ausgangsleitung (31a) angeordnet ist und

- ein zweiter induktiver Messsensor (30b) im Bereich der zweiten Speiseleitung (21b) und/oder im Bereich der zweiten Ausgangsleitung (31b) angeordnet ist,

- mindestens ein Integrator (28) vorgesehen ist, der eingerichtet ist, die Sensorsignale der induktiven Messsensoren (30a, 30b) zu integrieren,

- eine Steuereinheit (24) vorgesehen ist, die eingerichtet ist, die integrierten Sensorsignale zu vorgegebenen Zeitpunkten innerhalb der Schaltperioden auszulesen und in Abhängigkeit davon mindestens ein Ausgangssignal (sa1, sa2, sa3) zu erzeugen,

**dadurch gekennzeichnet, dass**
der erste induktive Messsensor (30a) und der zweite induktive Messsensor (30b) in Reihe geschaltet sind.

2. Vorrichtung nach Anspruch 1, **dadurch gekennzeichnet, dass** der Wert des mindestens einen Ausgangssignals (sa1, sa2, sa3) abhängig ist von der Differenz zweier zuvor ausgelesener integrierter Sensorsignale und somit von dem Wert des Laststromes ($i_L$).

3. Vorrichtung nach Anspruch 1 oder 2, **dadurch gekennzeichnet, dass** der vorgegebene Zeitpunkt zum Auslesen der integrierten Sensorsignale im Wesentlichen mitten innerhalb einer jeden Schaltperiode liegt.

4. Vorrichtung nach einem der vorigen Ansprüche, **dadurch gekennzeichnet, dass** eines des mindestens einen Ausgangssignals (sa1, sa2) einer Treibereinrichtung (22a, 22b) zugeführt wird, die daraufhin den von den Leistungsstufen (16a, 16b) abgegebenen Laststrom ($i_L$) beeinflussen.

5. Vorrichtung nach einem der vorigen Ansprüche, **dadurch gekennzeichnet, dass** eines des mindestens einen Ausgangssignals (sa3) einer Anzeigevorrichtung (25) zugeführt wird, die daraufhin ein entsprechendes optisches und/oder akustisches Signal abgibt, wodurch beispielsweise auf einen Überstrom oder einen Kurzschluss hingewiesen werden kann.

6. Vorrichtung nach einem der vorigen Ansprüche, **dadurch gekennzeichnet, dass** die induktiven Messsensoren (30a, 30b) Teile einer Spule (30) sind.

7. Vorrichtung nach einem der vorigen Ansprüche, **dadurch gekennzeichnet, dass** zumindest einer der induktiven Messsensoren (30a, 30b) als Rogowskispule ausgebildet ist.

8. Vorrichtung nach einem der vorigen Ansprüche, **dadurch gekennzeichnet, dass** zumindest einer der induktiven Messsensoren (30a, 30b) realisiert ist durch ein strukturiertes metallisches Element (133, 134, 135), das um eine Öffnung (48; 50) innerhalb einer elektrischen Platine verläuft.

9. Vorrichtung nach dem vorigen Anspruch, **dadurch gekennzeichnet, dass** die erste Speiseleitung (21a) und/oder die zweite Speiseleitung (21b) zumindest teilweise durch eine der Öffnungen (48; 50) verläuft.

10. Vorrichtung nach einem der beiden vorigen Ansprüche, **dadurch gekennzeichnet, dass** die erste Ausgangsleitung (31a) und/oder die zweite Ausgangsleitung (31b) zumindest teilweise durch eine der Öffnungen (48; 50) verläuft.

11. Verfahren zur Bestimmung eines Laststromes ($i_L$), der von einer Versorgungseinrichtung abgegeben wird, die eine erste Leistungsstufe (16a) und eine zweite Leistungsstufe (16b) aufweist, wobei

- die erste Leistungsstufe (16a) über eine erste Speiseleitung (21a) mit einem ersten Speisestrom ($i_1$) gespeist werden kann und einen ersten Ausgangsstrom über eine erste Ausgangsleitung (31a) abgeben kann,

- die zweite Leistungsstufe (16b) über eine zweite Speiseleitung (21b) mit einem zweiten Speisestrom ($i_2$) gespeist werden kann und einen zweiten Ausgangsstrom über eine zweite Ausgangsleitung (31b) abgeben kann,

- die Leistungsstufen (16a, 16b) wechselseitig für jeweils eine vorgegebene Schaltperiode mit endlicher Stromänderung (di/dt) geschaltet werden können, wodurch die Werte der Speiseströme ($i_1$; $i_2$) bzw. die Werte der

EP 3 170 010 B1

Ausgangsströme beeinflusst werden,
- ein erstes Sensorsignal von einem ersten induktiven Messsensor (30a) erzeugt wird, der Stromänderungen im Bereich der ersten Speiseleitung (21a) und/oder im Bereich der ersten Ausgangsleitung (31 a) erfasst, ein zweites Sensorsignal von einem zweiten induktiven Messsensor (30b) erzeugt wird, der Stromänderungen im Bereich der zweiten Speiseleitung (21b) und/oder im Bereich der zweiten Ausgangsleitung (31b) erfasst,
- das erste und das zweite Sensorsignal in Reihe geschaltet und integriert werden,
- die integrierten Sensorsignale zu vorgegebenen Zeitpunkten innerhalb der Schaltperioden ausgelesen werden und in Abhängigkeit davon mindestens ein Ausgangssignal (sa1, sa2, sa3) erzeugt wird.

12. Verfahren nach dem ersten Verfahrensanspruch, **dadurch gekennzeichnet, dass** der Wert des mindestens einen Ausgangssignals (sa1, sa2, sa3) abhängig ist von der Differenz zweier zuvor ausgelesener integrierter Sensorsignale und somit von dem Wert des Laststromes ($i_L$).

13. Verfahren nach einem der vorigen Verfahrensansprüche, **dadurch gekennzeichnet, dass** der vorgegebene Zeitpunkt zum Auslesen der integrierten Sensorsignale im Wesentlichen mitten innerhalb einer jeden Schaltperiode liegt.

14. Verfahren nach einem der vorigen Verfahrensansprüche, **dadurch gekennzeichnet, dass** eines des mindestens einen Ausgangssignals (sa1, sa2) zur Regelung des von den Leistungsstufen (16a, 16b) abgegebenen Laststromes ($i_L$) dient.

15. Verfahren nach einem der vorigen Verfahrensansprüche, **dadurch gekennzeichnet, dass** ein optisches und/oder akustisches Signal erzeugt wird, das abhängig ist von dem Wert eines des mindestens einen Ausgangssignals (sa3), wodurch beispielsweise auf einen Überstrom oder einen Kurzschluss hingewiesen werden kann.

**Claims**

1. Apparatus for determining a load current ($i_L$), which is output by a supply device, which has a first power stage (16a) and a second power stage (16b), wherein

    - the first power stage (16a) can be fed with a first feed current ($i_1$) via a first feed line (21a) and can output a first output current via a first output line (31a),
    - the second power stage (16b) can be fed with a second feed current ($i_2$) via a second feed line (21b) and can output a second output current via a second output line (31b),
    - the power stages (16a, 16b) can be switched alternately via a first control line (23a) or via a second control line (23b), respectively, by a control unit (24) for a respective predefined switching period with a finite current change (di/dt), as a result of which the values of the feed currents ($i_1$; $i_2$) or the values of the output currents, respectively, are influenced.
    - a first inductive measurement sensor (30a) is arranged in the region of the first feed line (21a) and/or in the region of the first output line (31a) and
    - a second inductive measurement sensor (30b) is arranged in the region of the second feed line (21b) and/or in the region of the second output line (31b),
    - aL least one integrator (28) is provided, which is configured to integrate the sensor signals of the inductive measurement sensors (30a, 30b),
    - a control unit (24) is provided, which is configured to read out the integrated sensor signals at predefined times within the switching periods and, depending thereon, to generate at least one output signal (sa1, sa2, sa3),

    **characterized in that**
    the first inductive measurement sensor (30a) and the second inductive measurement sensor (30b) are connected in series.

2. Apparatus according to Claim 1, **characterized in that** the value ol the at least one output signal (sa1, sa2, sa3) is dependent on the difference between two previously read-out integrated sensor signals and therefore on the value of the load current ($i_L$) -

3. Apparatus according to Claim 1 or 2, **characterized in that** the predefined Lime for reading out the integrated sensor signals is substantially mid-way within each switching period.

9

4. Apparatus according to one of the preceding claims, **characterized in that** one of the at least one output signals (sa1, sa2) is fed to a driver device (22a, 22b), which subsequently influences the load current ($i_L$) output by the power stages (16a, 16b).

5. Apparatus according to one of the preceding claims, **characterized in that** one of the at least one output signals (sa3) is fed to a display apparatus (25), which subsequently outputs a corresponding optical and/or acoustic signal, as a result of which, for example, an overcurrent or a short circuit can be indicated.

6. Apparatus according to one of the preceding claims, **characterized in that** the inductive measurement sensors (30a, 30b) are parts of a coil (30).

7. Apparatus according to one of the preceding claims, **characterized in that** at least one of the inductive measurement sensors (30a, 30b) is configured as a Rogowski coil.

8. Apparatus according Lo one of the preceding claims, **characterized in that** at least one of the inductive measurement sensors (30a, 30b) is realized by way of a structured metallic element (133, 134, 135), which runs around an opening (48; 50) within an electrical printed circuit board.

9. Apparatus according to the preceding claim, **characterized in that** the first feed line (21a) and/or the second feed line (21b) runs at least partly through one of the openings (48; 50).

10. Apparatus according to one of the two preceding claims, **characterized in that** the first output line (31a) and/or the second output line (31b) runs at least partly through one of the openings (48; 50) .

11. Method for determining a load current ($i_L$), which is output by a supply device, which has a first power stage (16a) and a second power stage (16b), wherein

    - the first power stage (16a) can be fed with a first feed current ($i_1$) via a first feed line (21a) and can output a first output current via a first output line (31a),
    - the second power stage (16b) can be fed with a second feed current ($i_2$) via a second feed line (21b) and can output a second output current via a second output line (31b),
    - the power stages (16a, 16b) can be switched alternately for a respective predefined switching period with a finite current change (di/dt), as a result of which the values of the feed currents ($i_1$; $i_2$) or the values of the output currents, respectively, are influenced,
    - a first sensor signal is generated by a first inductive measurement sensor (30a), which detects current changes in the region of the first feed line (21a) and/or in the region of the first output line (31a),
    - a second sensor signal is generated by a second inductive measurement sensor (30b), which detects current changes in the region of the second feed line (21b) and/or in the region of the second output line (31b),
    - the first and the second sensor signal are connected in series and integrated,
    - the integrated sensor signals are read out at predefined times within the switching periods and, depending thereon, at least one output signal (sa1, sa2, sa3) is generated.

12. Method according to the first method claim, **characterized in that** the value of the at least one output signal (sa1, sa2, sa3) is dependent on the difference between two previously read-out integrated sensor signals and therefore on the value of the load current ($i_L$).

13. Method according to one of the preceding method claims, **characterized in that** the predefined time for reading out the integrated sensor signals is substantially mid-way within each switching period.

14. Method according to one of the preceding method claims, **characterized in that** one of the at least one output signals (sa1, sa2) serves to control the load current ($i_L$) output by the power stages (16a, 16b).

15. Method according to one of the preceding method claims, **characterized in that** an optical and/or acoustic signal, which is dependent on the value of one of the at least one output signals (sa3), is generated, as a result of which, for example, an overcurrent or a short circuit can be indicated.

**Revendications**

1. Dispositif permettant de de terminer un courant de charge ($i_L$) délivré par un équipement d'approvisionnement qui présente un premier étage de puissance (16a) et un deuxième étage de puissance (16b), dans lequel

   - le premier étage de puissance (16a) peut être alimenté par un premier courant d'alimentation ($i_1$) par l'intermédiaire d'une première ligne d'alimentation (21a), et peut délivrer un premier courant de sortie par l'intermédiaire d'une première ligne de sortie (31a),
   - le deuxième étage de puissance (16b) peut être alimenté par un deuxième courant d'alimentation ($i_2$) par l'intermédiaire d'une deuxième ligne d'alimentation (21b), et peut délivrer un deuxième courant de sortie par l'intermédiaire d'une deuxième ligne de sortie (31b),
   - les étages de puissance (16a, 16b) peuvent être commutés en alternance par une unité de commande (24), par l'intermédiaire d'une première ligne de commande (23a) ou par l'intermédiaire d'une deuxième ligne de commande (23b), pendant respectivement une période de commutation prédéfinie à variation de courant finie (di/dt) de sorte que les valeurs des courants d'alimentation ($i_1$ ; $i_2$) ou les valeurs des courants de sortie peuvent être influencées,
   - un premier capteur de mesure inductif (30a) est disposé au niveau de la première ligne d'alimentation (21a) et/ou au niveau de la première ligne de sortie (31a), et
   - un deuxième capteur de mesure inductif (30b) est disposé au niveau de la deuxième ligne d'alimentation (21b) et/ou au niveau de la deuxième ligne de sortie (31b),
   - au moins un intégrateur (28) est prévu qui est aménagé pour intégrer les signaux de capteur des capteurs de mesure inductifs (30a, 30b),
   - une unité de commande (24) est prévue qui est aménagée pour extraire les signaux de capteur intégrés à des instants prédéfinis dans les périodes de commutation, et pour générer au moins un signal de sortie (sa1, sa2, sa3) en fonction de ceux-ci,

   **caractérisé en ce que** le premier capteur de mesure inductif (30a) et le deuxième capteur de mesure inductif (30b)sont connectés en série.

2. Dispositif selon la revendication 1, **caractérisé en ce que** la valeur de l'au moins un signal de sortie (sa1, sa2, sa3) dépend de la différence de deux signaux de capteur intégrés, extraits précédemment, et donc de la valeur du courant de charge ($i_L$).

3. Dispositif selon la revendication 1 ou 2, **caractérisé en ce que** l'instant prédéfini pour extraire les signaux de capteur intégrés se situe substantiellement au milieu de chaque période de commutation.

4. Dispositif selon l'une quelconque des revendications précédentes, **caractérisé en ce que** l'un de l'au moins un signal de sortie (sa1, sa2) est amené à un équipement d'excitation (22a, 22b) qui influence ensuite le courant de charge ($i_L$) délivré par les étages de puissance (16a, 16b).

5. Dispositif selon l'une quelconque des revendications précédentes, **caractérisé en ce que** l'un de l'au moins un signal de sortie (sa3) est amené à un dispositif d'affichage (25) qui délivre ensuite un signal aptique et/ou acoustique correspondant(s) de sorte que par exemple une surintensité ou un court-circuit peut être signalé(e).

6. Dispositif selon l'une quelconque des revendications précédentes, **caractérisé en ce que** les capteurs de mesure inductifs (30a, 30b) sont des pièces d'une bobine (30).

7. Dispositif selon l'une quelconque des revendications précédentes, **caractérisé en ce qu'**au moins l'un des capteurs de mesure inductifs (30a, 30b) est réalisé sous la forme d'une bobine de Rogowski.

8. Dispositif selon l'une quelconque des revendications précédentes, **caractérisé en ce qu'**au moins l'un des capteurs de mesure inductifs (30a, 30b) est réalisé par un élément métallique structuré (133, 134, 13b) qui s'étend autour d'une ouverture (48 ; 50) à l'intérieur d'une platine électrique.

9. Dispositif selon la revendication précédente, **caractérisé en ce que** la première ligne d'alimentation (21a) et/ou la deuxième ligne d'alimentation (21b) s'étend(ent) au moins en partie à travers l'une des ouvertures (48 ; 50).

10. Dispositif selon l'une des deux revendications précédentes, **caractérisé en ce que** la première ligne de sortie (31a) et/ou la deuxième ligne de sortie (31b) s'étend(ent) au moins en partie à travers l'une des ouvertures (18 ; 50).

11. Procédé permettant de déterminer un courant de charge ($i_L$) qui est délivré par un équipement d'approvisionnement qui présente un premier étage de puissance (16a) et un deuxième étage de puissance (16b), dans lequel

- le premier étage de puissance (16a) peut être alimenté par un premier courant d'alimentation ($i_1$) par l'intermédiaire d'une première ligne d'alimentation (21a), et peut délivrer un premier courant de sortie par l'intermédiaire d'une première ligne de sortie (31a),
- le deuxième étage de puissance (16b) peut être alimenté par un deuxième courant d'alimentation ($i_2$) par l'intermédiaire d'une deuxième ligne d'alimentation (21b), et peut délivrer un deuxième courant de sortie par l'intermédiaire d'une deuxième ligne de sortie (31b),
- les étages de puissance (16a, 16b) peuvent être commutés en alternance pendant respectivement une période de commutation prédéfinie ayant une variation de courant finie (di/dt) de sorte que les valeurs des courants d'alimentation ($i_1$ ; $i_2$) ou les valeurs des courants de sortie peuvent être influencées,
- un premier signal de capteur est généré par un premier capteur de mesure inductif (30a) qui détecte des variations de courant au niveau de la première ligne d'alimentation (21a) et/ou au niveau de la première ligne de sortie (31a),
- un deuxième signal de capteur est généré par un deuxième capteur de mesure inductif (30b) qui détecte des variations de courant. au niveau de 1a deuxième ligne d'alimentation (21b) et/ou au niveau de la deuxième ligne de sortie (31b),
- le premier et le deuxième signal de capteur sont connectés en série et intégrés,
- les signaux de capteur intégrés sont extraits à des instants prédéfinis dans les périodes de commutation, et au moins un signal de sortie (sa1, sa2, sa3) est généré en fonction de ceux-ci.

12. Procédé selon la première revendication de procédé, **caractérisé en ce que** la valeur de l'au moins un signal de sortie (sal, sa2, sa3) dépend de la différence de deux signaux de capteur intégrés, extraits précédemment, et donc de la valeur du courant de charge ($i_L$).

13. Procédé selon l'une quelconque des revendications de procédé précédentes, **caractérisé en ce que** l'instant prédéfini pour extraire les signaux de capteur intégrés se situe substantiellement au milieu de chaque période de commutation.

14. Procédé selon l'une quelconque des revendications de procédé précédentes, **caractérisé en ce que** l'un de l'au moins un signal de sortie (sa1, sa2) sert à réguler le courant de charge ($i_L$) délivré par les étages de puissance (16a, 16b).

15. Procédé selon l'une quelconque des revendications de procédé précédentes, **caractérisé en ce qu'**un signal optique et/ou acoustique est généré qui dépend de la valeur d'un de l'au moins un signal de sortie (sa3) de sorte que par exemple une surintensité ou un court-circuit peut être signalé(e).

Fig. 1

Fig. 2

Fig. 3

Fig. 4

Fig. 5

a)

$i_L$

t

b)

$u_{GS1}$

t

c)

$i_1$

t

d)

$i_2$

t

e)

$u_R$

t

f)

$\int u_R dt$

t

g)

$M$

t

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102009046255 A1
- EP 1073908 B1
- DE 69915816 T2
- DE 10107791 A1
- DE 102012210261 A1
- US 5815391 A